# EUROPEAN PATENT SPECIFICATION

(11) **EP 0 305 951 B1**
(45) Date of publication and mention of the grant of the patent: **02.02.1994**
(21) Application number: 88114058.6
(22) Date of filing: 29.08.1988
(51) Int. Cl.: G01R 1/04

(54) **Testing of integrated circuit devices on loaded printed circuit boards**
Prüfen von integrierten Schaltungen auf einer bestückten Leiterplatte
Contrôle de circuits intégrés sur une plaque de circuit intégré pourvue de composants

(30) Priority: 31.08.1987 US 91536; 12.01.1988 US 142990; 01.07.1988 US 214365
(43) Date of publication of application: 08.03.1989
(73) Proprietor: EVERETT/CHARLES CONTACT PRODUCTS INC., Pomona California 91767 (US)
(72) Inventor: van Loan, David R., Diamond Bar California 91765 (US); Swart, Mark Andrew, Upland California 91786 (US); Johnston, Charles Joseph, Walnut California 91789 (US)
(74) Representative: Grünecker, Kinkeldey, Stockmair & Schwanhäusser Anwaltssozietät

(56) References cited:
- GB-A- 2 061 630
- US-A- 3 573 617
- US-A- 3 701 077
- US-A- 4 138 186
- RIM Electronic Handbook, 1985, p. 601

## Description

### FIELD OF THE INVENTION

This invention relates to a translator for use in testing printed circuit boards and to a method for testing electrical continuity of circuit elements on a printed circuit board.

### BACKGROUND OF THE INVENTION

Circuit board test systems are used to test large numbers of printed circuit boards by verifying electrical functionality and continuity between various test points on the circuit board. Continuity and lack of continuity are generally detected through the use of test fixtures having an array of test probes for making electrical contact with individual test points on the printed circuit board. Test systems vary in their approach to bringing the array of test probes into contact with test points on the circuit board. One test system for testing loaded circuit boards includes spring biased test probes mounted on a probe plate, and a bellows or vacuum-actuated means of applying pressure between the spring probes and the circuit board test points. The test system also includes a test analyzer which generally includes a computer-controlled detection system for applying selected electrical signals to selected contacts to sense continuity and provide test results. An example of a prior art test system is described in U.S. Patent 4,138,186 to Long, et al.

Loaded printed circuit boards are usually crowded with various electrical components, including arrays of integrated circuit packages. These packages typically include integrated circuits packaged in an insulated housing with a plurality of thin, parallel electrical leads extending from the housing. The leads from the integrated circuit package can be bent into various configurations which makes testing of the packages difficult. For instance, integrated circuit packages with J-lead or gull-wing lead configurations are common. It is common to mount large numbers of these integrated circuit packages close to one another on the circuit board to save board space. If a number of integrated circuit packages are crowded together on a loaded circuit board, there is usually little room left around the integrated circuit packages for making electrical contact between spring probes on a test unit and the leads on the circuit packages or other circuit elements adjacent to the packages.

Semiconductor chips are often produced in dual in-line packages having two sets of spaced apart leads extending along opposite sides of the package. In testing dual in-line packages, the package is commonly plugged into a test head so that the leads on the integrated circuit package engage the test head contacts to perform a series of tests, after which the circuit package is removed from the test head. Test heads for such integrated circuit packages are described in U.S. Patents 3,701,077 to Kelly, Jr., and 3,573,617 to Randolph, et al. In most instances, these test heads are used for testing dual in-line packages before they are mounted on printed circuit boards. It is difficult to test dual in-line packages and other integrated circuit packages after they are mounted on a loaded circuit board, especially when the packages are crowded together on the board. Loaded circuit boards are normally tested with the test units described above, in which the spring probes are arranged to make electrical contact with the various test points on the board. In order for the test unit to make electrical contact with rows of leads on integrated circuit packages, it has been proposed to mount integrated circuit test heads, or test sockets, on the probe plate of the test fixture. When the probe plate and printed circuit board are drawn together in the test unit, the test socket passes around the perimeter of the integrated circuit package for making electrical contact with the leads on the package. However, several problems arise from this arrangement:
(a) If the packages are not accurately aligned with the test sockets, the test sockets may not fit around the integrated circuit package.
(b) It is necessary to make special cut-outs in the probe plate for mounting the test sockets.
(c) With the cut-outs in the probe plate, it is difficult to mount spring probes closely adjacent to the cut-out for contacting components closely adjacent to the integrated circuit packages.
(d) Relatively high pressure is required to force the test socket contacts into electrical contact with the leads on the integrated circuit package.

In addition to dual in-line packages, many integrated circuit packages are now available using surface-mount packaging technology which packs electronic functions more densely on circuit boards. This dense packing enables manufacturers to produce smaller boards at lower cost or to provide more functions at the same cost when compared with dual in-line packaging techniques. One common form of surface-mount packaging is the so-called plastic leaded chip-carrier (PLCC) package. Generally speaking, PLCC packages house memory and microprocessor integrated circuit chips requiring large numbers of leads spaced apart along all four sides or at least two opposite sides of a square shaped housing. Because of their small size and large number of leads, it is difficult to test multiple arrays of closely spaced apart PLCC devices mounted on loaded printed circuit boards. The configuration of the leads also makes it difficult to test PLCC devices. In some integrated circuit packages, the lead configuration prevents any contact being made between the leads and the test probes of a test unit. For instance, in packages with leads in a gull-wing configuration, the solder joints are sensitive to external pressures and therefore contact with test probes should be avoided to prevent fracturing the solder joints.

In GB-A-2 061 630, an apparatus for testing printed circuit boards is described which comprises a probe carrier which is drilled with a pattern of holes corresponding to the pattern of component mounting holes of a printed circuit board. Tubes are fitted in the holes, each tube being fitted with a spring-loaded probe. The probes are connected via wires to standard plugs, which in turn are plugged into sockets, to be linked to a test controller. When testing a printed circuit board, the probe carrier is pressed against the printed circuit board to achieve contact between the spring-loaded probes and the corresponding component mounting holes of the printed circuit board. The standard plugs comprise, at their surfaces, arrays of contacts to which the mentioned wires are linked. Each of the contacts on the surface of a plug is internally connected to one of the pins of the plug.

From RIM Electronic Handbook, page 601, 1985, a test clip is known that can be clipped on to an integrated circuit by placing the test clip over the integrated circuit and moving a ring into the direction of the integrated circuit in order to apply pressure to the contacts of the ring that contact the pins of the integrated circuit.

It is the object of the present invention to provide a translator module which facilitates the testing of loaded printed circuit boards having large numbers of integrated circuit packages mounted close to one another on the board and to provide a method for testing circuit boards having multiple integrated circuit packages mounted in various patterns on different boards.

These objects are solved by the subject matters of Claims 1 and 9.

Briefly, one embodiment of this invention comprises a translator module that can mounted over an integrated circuit package located on a loaded printed circuit board. The translator module makes contact with rows of spaced apart leads adjacent the integrated circuit package. The module can facilitate circuit verification by a test unit having an array of test probes for use in contacting individual test points on the board. The translator module includes a housing adapted to fit over the integrated circuit package, together with first and second rows of spaced apart electrical contacts arranged along side walls of the housing for making contact with corresponding rows of leads adjacent the circuit package. In one embodiment, a plurality of spaced apart electrically conductive test pads are disposed in a substantially common plane on a top side of the module housing. These test pads are arranged in a pattern for making contact with individual test probes of a circuit continuity test analyzer. The test pads on the module housing are electrically connected internally to corresponding contacts in the first and second rows of module contacts, so that electrical contact between the leads associated with the circuit package and corresponding contacts on the module is translated to individual test probes in the test unit for use in verifying electrical connections between the circuit package and circuit elements on the printed circuit board.

In one form of the invention, the rows of spaced apart contacts on the test module housing are arranged for independent releasable spring biased contact with corresponding leads on the integrated circuit package. In another embodiment, where contact with the leads of the integrated circuit package should be avoided, the test module housing carries separate movable contacts arranged for pressure contact with corresponding electrical leads (conductors or pads) on a printed circuit board to which the leads of the integrated circuit package are individually connected. In this embodiment, means are provided for ensuring good pressure contact between individual contacts on the test module housing and the individual conductors on the printed circuit board.

The translator module can be easily mounted over the integrated circuit package prior to testing. In one embodiment, a plurality of translator modules are mounted over separate integrated circuit packages that can be located in any of various patterns on a loaded printed circuit board. Even if the circuit packages are crowded together, the rows of contacts are arranged on the modules so that reliable contact is made simultaneously with the leads adjacent the closely spaced circuit packages. The pattern of test pads on the top of each module housing matches a predetermined pattern of test probes in the test unit. The printed circuit board with the translator modules in place is inserted into the test unit. As the test probes are drawn toward the printed circuit board, preselected test probes make electrical contact with corresponding test pads on the tops of the translator modules. Other test probes in the test unit are available to make contact with other electrical components, circuit elements, or conductors on the circuit board adjacent the translator modules. Since the pattern of test pads on each module can be arranged to match the pattern of test probes in the test unit, all electrical contact points on the printed circuit board, including all test points in the integrated circuit packages, can be quickly tested for continuity. A densely packed arrangement of leads on the circuit packages can be translated into a less densely packed arrangement of contact points on the top faces of the modules. This facilitates ease of contact with the spring probes of the test unit and accommodates tolerances within a reasonable range so that reliable testing can be done rapidly.

In one embodiment of the invention, the translator module comprises a molded plastic housing with metal leaf spring contacts facing downwardly along the edges of the housing. In another embodiment, the module is made from a "flex-circuit" material so that the contacts each comprise a thin metal film on a flexible plastic backing sheet in which the contacts have a memory for producing rows of spring-like contact fingers along the side edges of the module. The latter embodiment has space-saving advantages on densely packed loaded circuit board and reduced manufacturing costs.

In another form of the invention, the translator module is connected to the end of a flexible cable adapted to conduct test signals to a circuit verification test unit. The housing has separate rows of contacts for releasably contacting corresponding leads on or adjacent an integrated circuit package under test. Conductive leads on the cable are electrically connected to corresponding contacts on the housing. The housing and cable can be made from a flex-circuit material, and in one form of the invention, the module housing and contacts, at least in part, are formed integrally with the flex-circuit cable. In use, the module can be placed manually over each integrated circuit package under test. Test signals are conducted from the housing via the flex-circuit cable to the test analyzer for circuit verification testing. The flex cable, in some instances, can replace the test pads and the test probes which contact the text pads during testing.

One embodiment of the present invention provides a translator module particularly adapted for pressure contact with electrical leads (conductors or circuit traces) on the printed circuit board to which the leads on the integrated circuit package are directly connected. This embodiment avoids direct contact with the leads of the integrated circuit device where such contact is undesirable. This test module also occupies a minimum envelope of space around the integrated circuit package under test so that multiple integrated circuit packages crowded onto a loaded printed circuit board can be tested simultaneously with identical test modules. The spring contacts on the test module preferably comprise spring biased C-shaped beams with vertically extending end portions, the tips of which make vertical contact with the leads on the board. The C-shaped portions of the beams deflect upwardly internally into the test module housing above the respective points of pressure contact. Means are provided to uniformly pre-load the springs to a uniform height and load.

In another embodiment of the invention, a test unit is integrated into an integrated circuit chip carrier or package. An array of test pads are disposed on the exterior of an integrated circuit housing, and these test pads are separately connected internally to corresponding leads from the integrated circuit package. During testing, use of a separate translator module is avoided, and test probes from a test unit contact corresponding test pads on the exterior of the integrated circuit package for testing electrical continuity. This arrangement can be used to test loaded printed circuit boards, in which case continuity can be tested between the individual test probes and the connection of the leads from the package to the individual conductors on the printed circuit board.

These and other aspects of the invention will be more fully understood by referring to the following detailed description and the accompanying drawings.

### BRIEF DESCRIPTION OF THE DRAWINGS

FIG. 1 is a perspective view illustrating a translator module according to the principles of this invention.

FIG. 2 is a fragmentary semi-schematic side elevation view taken on line 2-2 of FIG. 1.

FIG. 3 is a top plan view illustrating detailed construction of internal circuitry within the translator module.

FIG. 4 is a fragmentary semi-schematic side elevation view, partly in cross-section, illustrating use of multiple translator modules with a typical circuit continuity test unit.

FIG. 5 is a semi-schematic side elevation view illustrating a prior art plastic leaded chip-carrier (PLCC) on which the translator module is used for testing circuit continuity.

FIG. 6 is a semi-schematic top plan view taken on line 6-6 of FIG. 5.

FIG. 7 is a bottom plan view taken on line 7-7 of FIG. 5.

FIG. 8 is a fragmentary semi-schematic side elevation view, partly in cross-section, illustrating a means of contact between the translator module contacts and leads on a PLCC device under test.

FIG. 9 is an exploded perspective view illustrating an alternative embodiment of the translator module, in which the module is made from a "flex-circuit" material.

FIG. 10 is an exploded perspective view illustrating one step in a method for making the module of FIG. 9.

FIG. 11 is a top plan view illustrating the assembled module of FIG. 9 after a stamping step and before the module is folded and set in its final configuration.

FIG. 12 is a semi-schematic perspective view illustrating the completed test module.

FIG. 13 is a cross-sectional view taken on line 13-13 of FIG. 12.

FIG. 14 is a fragmentary semi-schematic view illustrating use of the alternative test module.

FIG. 15 is a fragmentary schematic cross-sectional view illustrating an alternative construction of the test module of FIGS. 9-13.

FIG. 16 is a schematic cross-sectional view illustrating a further alternative construction of the test module.

FIG. 17 is a fragmentary semi-schematic top view illustrating an alternative embodiment of a translator module made from a composite flex-circuit material.

FIG. 18 is a fragmentary schematic cross-sectional view taken on line 18-18 of FIG. 17.

FIG. 19 is a semi-schematic, partly cross-sectional view illustrating a means for assembling a translator module made from the composite flex-circuit material of FIGS. 17 and 18.

FIG. 20 is a fragmentary schematic cross-sectional view illustrating a portion of the completed module of FIG. 19.

### DETAILED DESCRIPTION

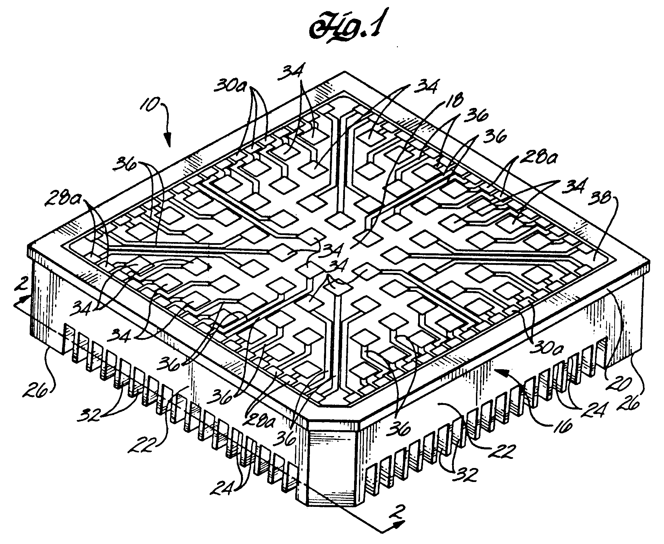

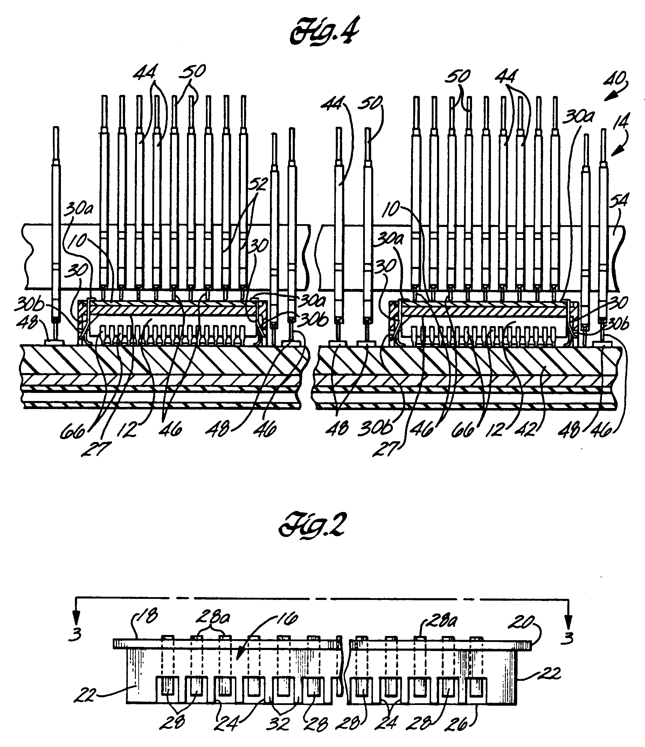

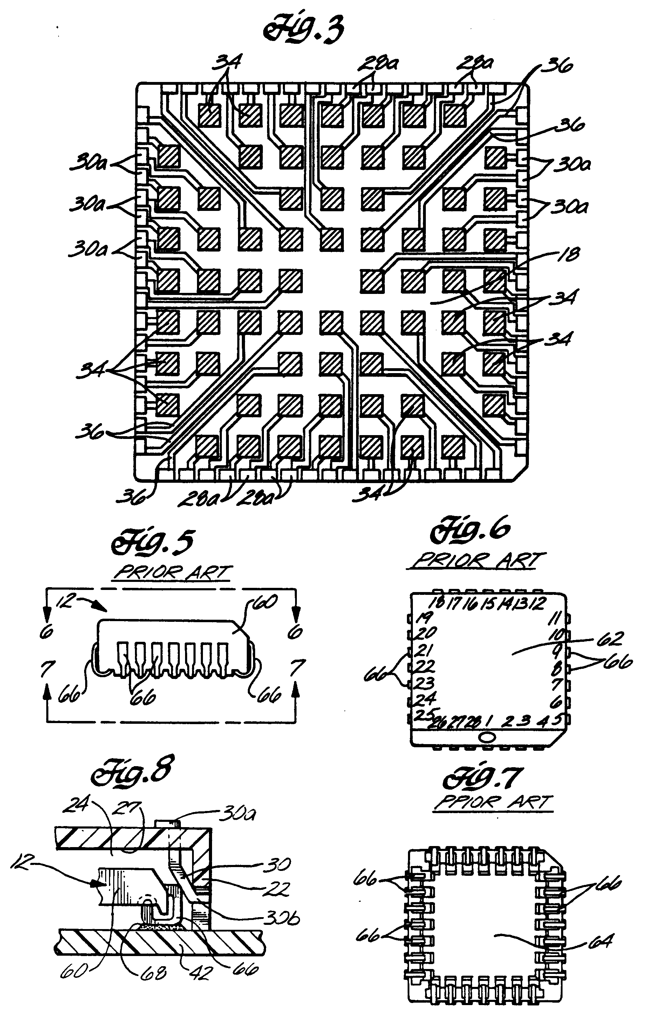

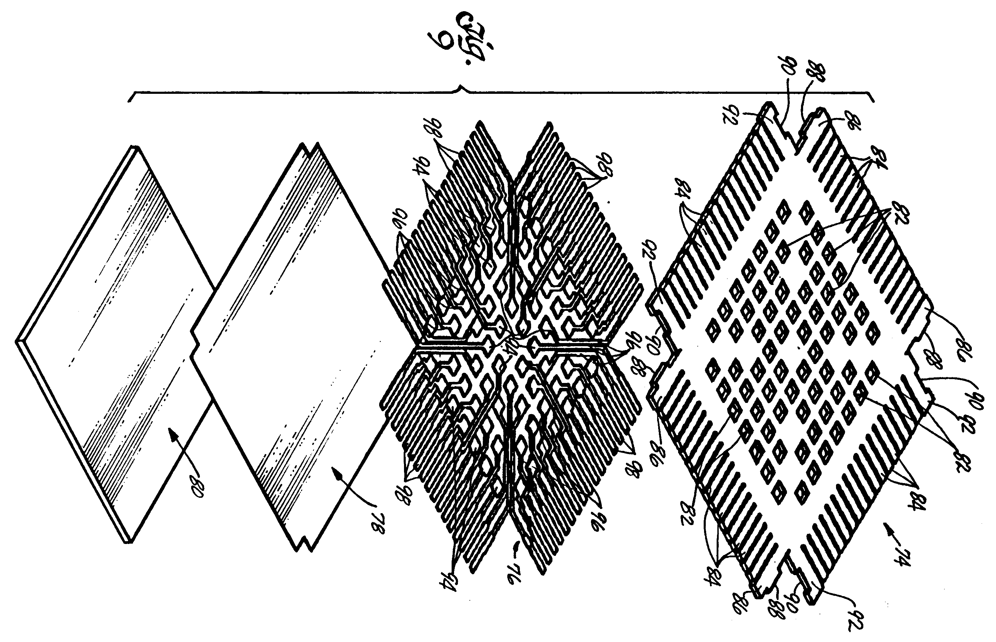

FIGS. 1 through 3 illustrate a translator module 10 adapted for releasable mounting over an integrated circuit package mounted on a loaded printed circuit board. The module 10 is particularly adapted for mounting on an integrated circuit package of the PLCC type. FIG. 4 illustrates an embodiment in which the module is mounted on a PLCC package 12 carried on a circuit board placed in a typical circuit verifying test unit 14.

The translator module 10 includes a housing 16 made from a material having electrical insulating properties. In one form of the invention, the housing is molded from hard plastic. The housing is generally rectangular or square when viewed in top plan view. The housing is molded to provide a flat upper surface 18 which can have a thin peripheral rim 20 extending around the perimeter of the housing above upright side walls 22 arranged rectangularly and extending below the upper surface of the housing. Separate rows of uniformly spaced apart and parallel slots 24 are formed along the underside of each of the four side walls of the housing. The slots are formed so that they open downwardly and extend above a flat bottom surface 26 of the housing. The bottom surface of the housing is parallel to the flat upper surface 18 of the housing. The underside of the housing also has a downwardly facing rectangular recess 27 inside the four outer rows of slots 24.

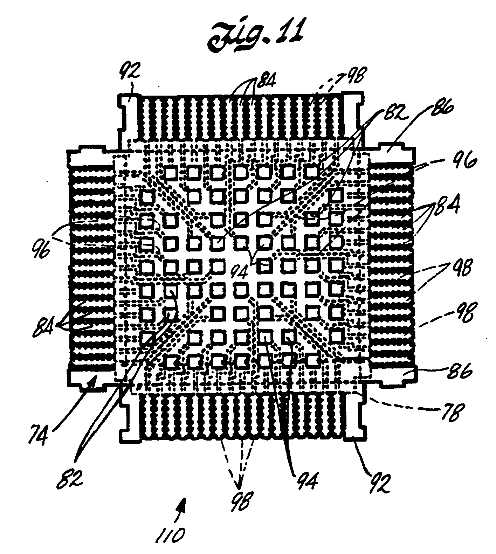

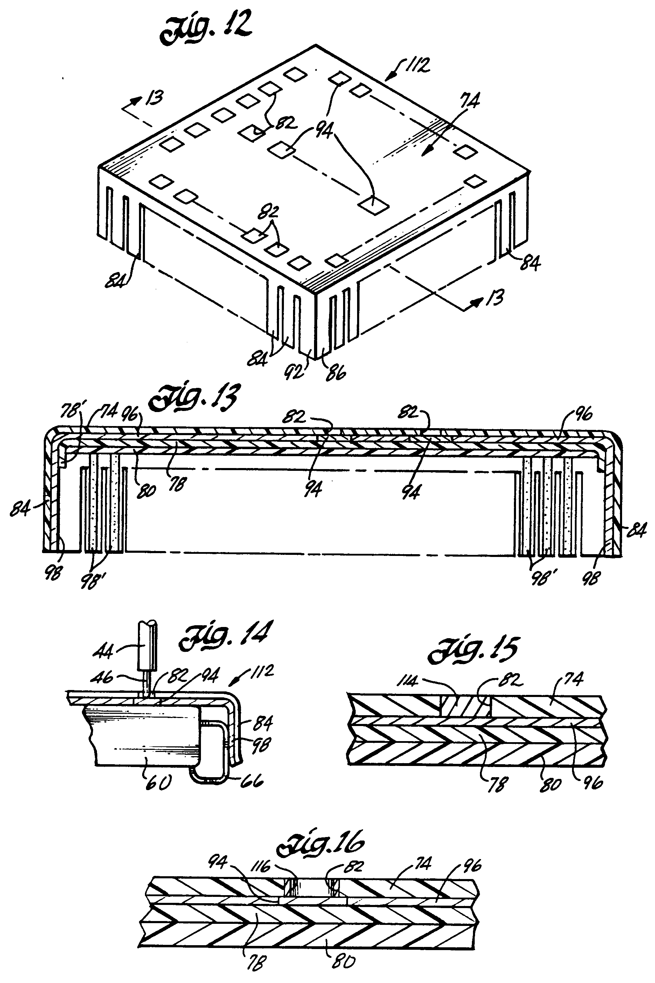

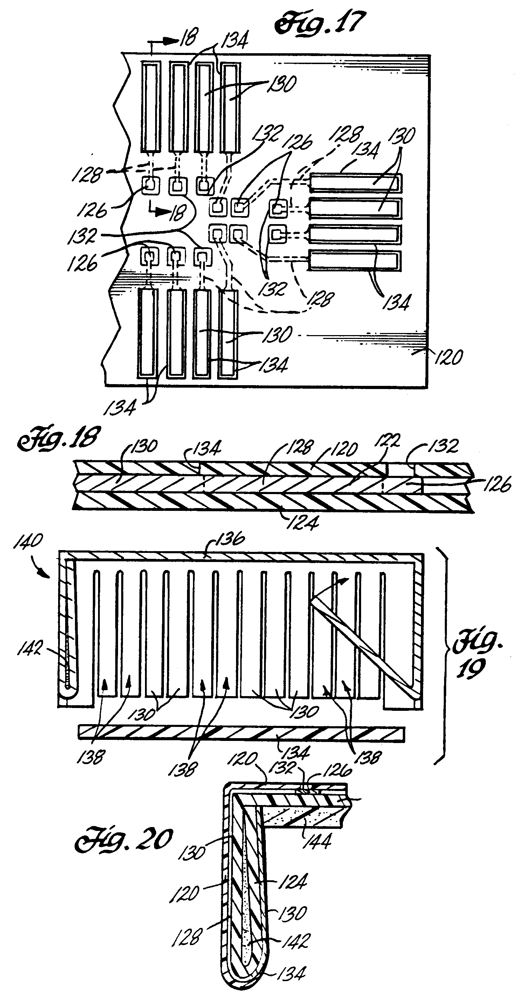

The bottom side of the translator module has first and second rows of leaf spring contacts 28 disposed in the slots 24 along two opposite side walls 22 of the housing. Third and fourth rows of similar leaf spring contacts 30 are disposed in the slots in the remaining pair of opposite side walls of the housing. The leaf spring contacts 28 in the first and second rows are shown in FIG. 2. FIG. 4 illustrates the leaf spring contacts 30 in the third and fourth rows. The leaf spring contacts 28 and 30 are arranged so that a separate contact is disposed in each of the slots 24 along all four sides of the housing. In the illustrated embodiment, the leaf spring contacts face outwardly in the open slots in the side walls of the housing and are thereby accessible from the exterior of the housing side walls 22. The leaf spring contacts also are mounted in the slots so that they are accessible from below the bottom surface 26 of the housing side walls. In a separate embodiment, the module may have only two rows of contacts in a pair of opposite sides of the module housing, for testing a circuit package having external leads on only two sides. As shown best in the side view of the leaf spring contacts 30 illustrated in FIGS. 4 and 8, each single leaf contact 28 or 30 has a top portion which extends perpendicularly to the plane of the top surface 18 of the housing. The top of each spring is bent over parallel with the top side of the housing as depicted at 30a in FIGS. 4 and 8. Thus, the top face 18 of the housing, as shown in FIG. 1, reveals first and second rows of these bent-over upper portions 28a of the leaf spring contacts 28 on opposite sides of the housing and third and fourth rows of the bent-over upper portions 30a of the leaf spring contacts along the remaining opposite sides of the housing. Referring again to the side view of the leaf spring contacts shown in FIG. 4, the lower portions of the contacts are bent at about their mid-point so that lower portions 28b and 30b of the contacts extend downwardly and outwardly at an angle toward the bottom of the slots in which the contacts are located.

Thus, the leaf spring contacts 28 and 30 are mounted in their individual slots 24 so that the contacts in each row along the four sides of the housing are uniformly spaced apart, extend parallel to one another, and are shielded from one another by the thin molded plastic partitions 32 that separate the slots from one another. Since leaf spring contacts in each row are arranged in their individual slots so that they face outwardly in each upright side wall of the housing while also facing downwardly in their respective slots, the contacts in each row can be urged outwardly toward the exterior of the housing in response to a force acting outwardly on the lower portion of each contact. The leaf spring contacts are adapted in this way to flex outwardly when the module housing is placed over an integrated circuit package having individual rows of leads that engage the leaf spring contacts. This use of the module is described in more detail below.

An array of contact points preferably in the form of planar test pads 34 faces upwardly from the top face 18 of the module 10. The test pads are preferably arranged in spaced apart and parallel rows on a uniform square matrix pattern, although the test pads may be arranged in other patterns if desired. The test pads are arranged so that each test pad located on the upper surface of the module corresponds to a separate one of the leaf spring contacts in the rows of contacts around the outside of the module. Electrical conductor means are provided internally to the housing for making a separate electrical connection between each test pad 34 and its corresponding leaf spring contact. Although various means for providing these separate and independent means of electrical connection can be provided, a preferred technique, illustrated in FIGS. 1 and 3, comprises electrically connecting each test pad 34 with its corresponding contact via separate circuit traces 36 of a conductive material extending from the pad to the bent-over top portion 28a or 30a of the corresponding contact. The electrically conductive circuit traces 36 are preferably applied to the top face 18 of the module by conventional integrated circuit etching techniques. In a preferred arrangement, the test pads 34 and the circuit traces 36 are applied to the top face of a separate printed circuit board 38. The printed circuit board is then mounted in a rectangular recess in the top face of the module housing. The top portions 28a and 30a of the leaf spring contacts 28 and 30, respectively, are bent over to make electrical contact with their corresponding circuit traces 36 after the board 38 is placed on the module. In an alternative technique, the module housing can be formed as a single piece with a flat upper face on which the conductive test pads 34 and their corresponding circuit traces 36 are silk-screened so that the ends of the separate circuit traces 36 make contact with the bent-over upper portions 28a and 30a of the leaf spring contacts 28 and 30.

Thus, the module housing 10 has four rows of uniformly spaced apart exposed leaf spring contacts facing outwardly and downwardly along a rectangular perimeter of the housing; and electrical contact from each spring is translated to a separate planar test pad on the upper face of the housing. As a result, the linear rows of closely spaced apart contacts are translated into a two-dimensionally arranged matrix of test pads in a plane having a surface area sufficient for the test pads to be mutually spaced apart on centers substantially farther apart than the individual in-line spacing of the contacts with which the tests pads are connected. Moreover, the large planar area of the module upper surface also allows individual test pads to occupy a two-dimensional area having a substantial dimension both longitudinally and laterally. In one embodiment, as illustrated in FIGS. 1 and 3, the module housing carries four separate rows of 17 spaced apart leaf spring contacts which are individually spaced apart on 1,27 mm in-line centers. These contacts are translated into the matrix of 68 test pads on 0.10 inch grid centers. The oversized test pads also allow a plus or minus 0.025 inch location tolerance for test probes of the test fixture described in more detail below. Other arrangements involving test modules with different numbers of contacts in each row and a different grid like arrangement of test pads also can be used without departing from the scope of the invention.

Use of the translator module 10 is best illustrated in FIG. 4, which shows a circuit verifying test system 40 for testing a loaded printed circuit board 42. The circuit board includes a plurality of the integrated circuit packages 12 mounted on an upper face of the board. The circuit board can be any of a large number of printed circuit boards having various circuit elements and integrated circuit packages interconnected electrically by etched electrically conductive circuit traces in the well known manner. The modular housing is used on the test systems by first placing a separate module over each circuit package on the circuit board. The modular housing shown in the drawings is especially adapted for mounting on integrated circuit packages of the PLCC type, and the circuit package 12 illustrated in the drawings represents a typical PLCC configuration. However, the translator module also may be adapted for mounting on other integrated circuit packages.

The test fixture 40 illustrated in FIG. 4 includes an array of spring loaded test probes 44. These spring loaded test probes have tips 46 at their lower ends which contact with individual test points 48 in the integrated circuits on the board 42. The types of test points can vary and they are represented schematically at 48 for simplicity. Terminals 50 at the opposite ends of the spring loaded test probes are typically wire-wrapped and electrically connected to a computer controlled circuit verifying system (not shown) in the well known manner. The verifying system tests electrical signals at the various predetermined test points 48 throughout the integrated circuit on the board 42 to verify the continuity or lack of continuity of the circuitry on the printed circuit board. The spring loaded probes 44 are mounted in separately drilled individual holes 52 in a spring probe plate 54 of the test unit. When the spring probe plate is placed over the integrated circuit board 42, the tips 46 of certain spring probes are automatically aligned with predetermined test points 48 of the integrated circuit for verifying electrical continuity at these portions of the circuit under test. For testing the circuitry associated with the integrated circuit packages 12 mounted on the board, the translator modules 10 are first separately mounted on each integrated circuit package. The upper face 18 of each mounted module faces upwardly toward the array of spring probes. The array of spring probes 44 corresponding to each PLCC device 12 is arranged on a pattern in the spring probe plate 54 so that each spring probe contacts a separate one of the test pads on the upper surface of the module during testing, as described in further detail below.

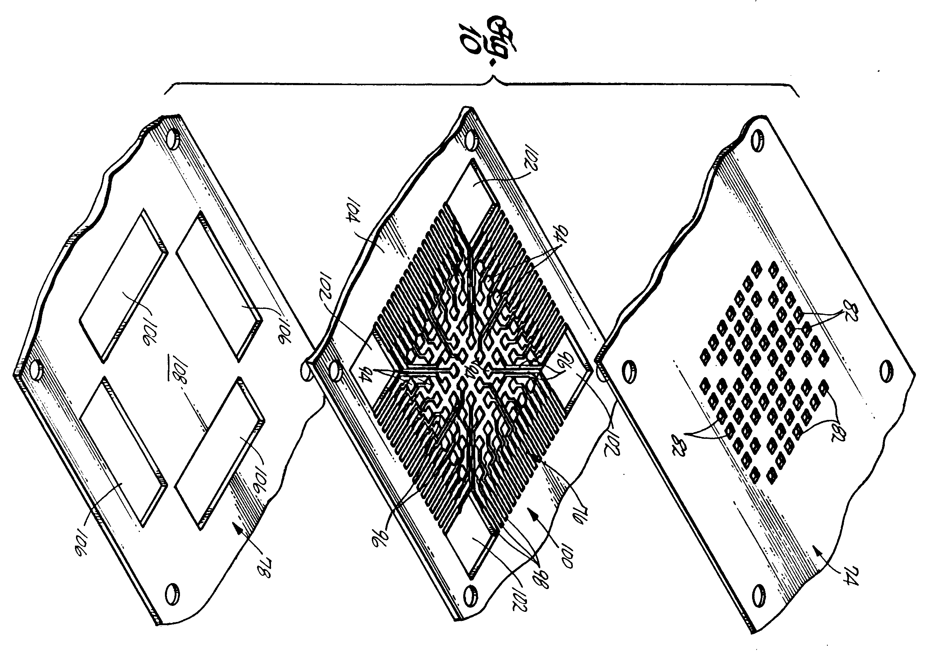

Prior to contacting the tops of the modules with the array of spring probes, the module is placed over the PLCC device by hand in a snap-on friction fit. FIG. 4 illustrates the modules positioned in their snap-on fit over corresponding PLCC devices board 42. To better understand how the translator module attaches to a PLCC device, FIGS. 5 through 7 illustrate the configuration of a typical PLCC package which includes a housing comprising a rectangular plastic block 60 having flat upper and lower surfaces 62 and 64. The PLCC housing typically contains computer memories and microprocessors in integrated circuit chip form. The illustrated PLCC device is a 28-pin arrangement having leads 66 formed in a "J" shape projecting downwardly from all four side walls of the housing. In the illustrated embodiment, there are seven uniformly spaced apart and parallel "J" leads 66 projecting from each planar side face of the housing. Each "J" lead extends outwardly along the outside of the side face of the block, closely spaced from and parallel to the upright side wall of the block. The lead is then curved underneath the block and extends into a corresponding slot at the bottom of the block. The bottom portion of each "J" lead protrudes downwardly below the bottom of the block sufficiently to be attached to a corresponding location on a printed circuit board. FIG. 8 illustrates a "J" lead 66 of the PLCC device 12 attached to the printed circuit board 42 by electrically conductive soldering 68. The PLCC device as shown in FIGS. 5 through 7 is for illustration purposes only inasmuch as various PLCC configurations ranging in pin sizes from 20 to 68 pins, for example, are presently available and can be used with various forms of the translator module of this invention.

As mentioned previously, a separate translator module is placed on each PLCC device by hand in a snap-on friction fit. The module is placed over the PLCC housing by first placing the bottom surface of the module over the top of the PLCC device to align the rows of contacts 28 and 30 along the sides of the module with corresponding "J" leads 66 on the PLCC device. The translator module is then pushed downwardly onto the PLCC device with a downwardly directed force so that each of the leaf spring contacts 28 and 30 is forced downwardly against a corresponding "J" lead so as to flex the leaf springs outwardly sufficiently to hold them in tension to thereby hold the module on top of the PLCC device in a snap-on friction fit. The underside of the module is hollowed out at 27 to accommodate the rectangular configuration of the PLCC housing. The bottom edge 26 of the module housing rests against the top surface of the printed circuit board when the module is in place on the circuit package. The leaf springs are forced outwardly into the configuration shown in FIG. 8 from their engagement with the leads on the PLCC device, the contacts are held under tension in that position to provide the frictional snap-lock engagement for holding the module on the PLCC device. In a circuit board having a number of these PLCC devices positioned in any of various patterns across the surface of the board, individual translator modules can be rapidly placed on corresponding PLCC devices prior to test. The array of spring probes in the probe plate 54 is arranged in a pre-determined pattern that automatically aligns the spring probes with the test pads 34 on each module.

Testing is then carried out by the usual step of drawing the spring probes into contact with the various test points in the circuit under test. In the example illustrated in FIG. 4, the test fixture can include a platen 70 at the bottom of the test unit on which the printed circuit board is mounted, together with a bellows 72 below the platen. The bellows can be expanded under pressure to force the platen upwardly to draw the spring probes into pressure contact with the circuit test points. Pressure within the bellows maintains the contact pressure between the bottoms of the spring probes and the test points in the circuit during circuit verification by the test unit. The test unit illustrated in FIG. 4 is by way of example only. Other test units such as vacuum-actuated test units, for example, also can be used.

The translator module translates densely packed in-line spacing of contacts on integrated circuit packages into a much wider spaced apart grid of oversized test pads for allowing substantial tolerances in the contact between the test unit test probes and the test pads on the module. Standard probes can be used and no milling or special machining is required for placing the probes in a position to test circuits produced by connections to any or all of the leads from the integrated circuit package. The leaf spring contacts also supply low initial contact force for ease of manual insertion of the integrated circuit package into the module. Under the force generated by probe compression, the leaf springs supply additional force complimented with a smooth wiping action to ensure good electrical contact. In one embodiment, the leaf springs can be configured at a angle so that when pressure from the probe plate is released the module moves away from the integrated circuit package automatically. The translator module also provides reliable circuit continuity to the test unit. Because the pads can be made large, rotation of this module due to a misaligned integrated circuit package does not prevent a spring probe from remaining in contact with a corresponding pad. Also, the rectangular or preferably square shape of the pads allows large spacing between the pads to be maintained while maximizing contact area on the pads. The module is especially useful in testing multiple circuit packages which are closely spaced from one another on the circuit board. The module, when mounted on a circuit package, occupies minimal space around the package. The arrangement of the leaf spring contacts in the slots, which can be open to the sides and bottom of the module, makes it possible to place the module in its operative position by a straight downward movement over the leads on the circuit package. Since the leaf spring contacts are supported from above, they require no supporting structure that occupies the lateral space around the perimeter of each integrated circuit package.

FIGS. 9 through 13 illustrate an alternate embodiment of the translator module. In this embodiment, the module is made from a metalized plastic "flex-circuit" material. FIG. 9 is an exploded perspective view showing individual elements of the alternate flex-circuit module in their final form before assembly. FIG. 10 is an exploded perspective view illustrating elements of the translator module during an early stage of the process for making the module. FIG. 11 is a view illustrating the elements of FIG. 9 assembled together and stamped into a desired shape before the stamping is formed into a finished translator module shown in FIGS. 12 and 13. FIGS. 14 and 15 are alternate embodiments of the flex-circuit test module of FIGS. 9 through 13.

Referring to FIG. 9, the flex-circuit module comprises a thin, flat, flexible plastic outer sheet 74 for forming an outer housing of the module; a circuit pattern 76 made from an electrically conductive material such as copper; an insulator film such as a thin, flat plastic backing sheet 78; and a rigidizing member 80 made from a more rigid supportive backing material.

The outer sheet 74 is preferably made from a thin flexible self-supporting plastic sheeting. A preferred material is a 20 mil thick sheet of polycarbonate resin such as the material known as Lexan, a trademark of General Electric Polymers Product Dept. The plastic material from which the outer sheet is made is capable of being shaped by a stamping process and is capable of being heat formed into a desired three-dimensional shape. The material also is spring-like in a sense that it retains a memory sufficient to spring back to a preset position after a bending force is released. The Lexan sheet 74 shown in FIG. 9 represents the results of two separate steps in the process of forming the flex-circuit module. The outer sheet 74 is a generally rectangular-shaped piece having a large central region with an array of cut-out holes 82 extending through the depth of the sheet. The cut-out holes are each generally rectangular in shape to match the shape of corresponding test pads for the flex-circuit module. The cut-out holes 82 are preferably formed by an initial stamping process. At a later stage of the process, four rows of mutually spaced apart and parallel flexible plastic spring-like fingers 84 are formed along the four sides of the rectangular sheet 74. The plastic fingers 84 are each long and narrow and semi-flexible. The fingers are of uniform length and width and are uniformly spaced apart with thin, narrow spaces between them. Each of the fingers is able to flex independently of the other fingers. Each row of fingers is spaced inwardly from the adjacent opposite corners of the sheet 74. This facilitates later folding or shaping of the outer sheet into a three-dimensional box or cube shape described below. The outer fingers 86 in opposite first and second rows of fingers are wider and have projections 88 for interlocking with corresponding recessed edges 90 of wider fingers 92 at the opposite ends of the other two rows of fingers. The wider fingers 86 and 92 at the ends of the row are interlocked during a later stage of the process in which the sheet 74 is formed into a box shape for forming an outer housing of the flex-circuit module. The rows of fingers are formed by a stamping process described below.

The conductive circuit pattern 76 is initially made from a thin, flat, continuous sheet of electrically conductive metal such as copper, approximately 2 to 5 mils thick. At this thickness, the copper layer is in thin, self-supporting sheet form. The copper sheet is preferably roll bonded initially to the plastic insulator film 78 and then later etched away to form the conductive circuit pattern shown at 76 in FIG. 9. In this embodiment, the plastic film 78 serves as a carrier for the etched metal circuit pattern. Alternatively, the conductive circuit pattern 76 can be formed by stamping a separate conductive metal sheet into the illustrated configuration. As a further alternative, the conductive circuit pattern can be formed on a flexible carrier by printed circuit techniques. The conductive circuit pattern 76 comprises an array of contact points, preferably in the form of planar test pads 94 arranged in spaced apart and parallel rows on a uniform square matrix pattern, although other patterns may be used if desired. The test pads are arranged so they lead to separate, elongated, thin metal conductor elements 96, which generally fan outwardly from the matrix of test pads to corresponding conductive metal fingers 98 arranged in rows along the four peripheral side portions of the circuit pattern. The conductive metal fingers 98 are of uniform length and width and have uniform spacing between them so as to match the pattern of corresponding flexible plastic fingers 84 on the outer sheet 74.

The insulator film sheet 78 preferably comprises a thin, flexible plastic film capable of being shaped by a stamping process and also capable of being heat-formed into a desired shape. The material is especially one to which the conductive metal film can be roll bonded prior to etching away to form the flexible circuit pattern 76. In a preferred form, the insulator film 78 comprises a 2 mil thick polyamide film such as Kapton, a trademark of Du Pont.

The rigidizing member 80 comprises a semi-rigid plastic sheet such as an approximately 30 mil thick piece of G-10 fiberglass.

FIG. 10 illustrates a preliminary step in the process for making the flex-circuit translator module. This illustration shows the flexible outer plastic sheet 74 aligned above a copper lead frame 100 having a stamped or etched conductive circuit pattern. The illustration shows the circuit pattern 76 with the centrally located array of conductive pads 74 which fan out to the long narrow conductive metal fingers 98 around the outside of the circuit pattern. The copper lead frame 100 also includes rectangular cut out hole 102 at the four corners of the circuit pattern. The lead frame 100 simply illustrates any of various intermediate steps in the process in which the circuit pattern 76 is formed from a continuous thin copper sheet. In the illustrated embodiment, the lead frame 100 would more likely represent a stamped lead frame in which each of the conductive circuit elements extends from the central test pads 94 out to their corresponding fingers 98, which, in turn, are integral with a rectangular outer peripheral frame 104. Alternatively, the lead frame 100 can represent an etched circuit pattern in which case the continuous thin copper sheet is preferably first roll bonded to the thin flexible plastic carrier film 78. This plastic sheet has large cut-out holes 106 aligned with the portions of the copper sheet at which the four rows of conductive fingers 98 will be formed. After roll bonding the thin copper sheet to the plastic sheet 78, the copper is etched away so that the array of conductive test pads 94 are formed over a central region 108 of the plastic sheet, while the conductive fingers 98 of the circuit pattern 76 bridge the cut-out holes 106. The width of the cut-out holes 106 can be slightly less than the length of the fingers so that each of the copper fingers 98 is bonded to the plastic carrier film 78 on opposite sides of the cut-out holes 106.

The outer plastic sheet 74, the lead frame 100 and the insulator sheet 78 are then overlaid and bonded to one another as a composite sheet, after which the resulting composite sheet is stamped to form a composite stamping 110 shown in FIG. 11. The outer plastic sheet 74 is bonded to the intermediate conductive copper layer by a suitable adhesive such as a heat-curable adhesive which is cured at a later stage of the process. The individual layers of the composite sheet also are preferably adhered to one another by a roll bonding technique in which the overlying layers are pressed between a pair of platens which apply heat and pressure to form the continuous flexible composite sheet prior to the stamping process. The multi-layer stamping 110 thus comprises the outer plastic layer 74 with the cut-out holes 82 aligned with the conductive metal test pads 94 at the base of each cut-out hole. The intermediate conductive metal layer of the stamping has the conductive metal elements 96 fanning outwardly from the array of upwardly facing test pads 94 toward the conductive metal fingers 96 on the underside of the corresponding plastic fingers 84. The base of the stamping comprises the insulator film 78 having its rectangular outer periphery inboard from the inner ends of the conductive fingers which extend around the periphery of the stamping.

The composite flexible stamping 110 is next formed into a three dimensional, downwardly opening box-shaped translator module 112 shown in FIG. 12. The module is preferably formed by placing the stamping 110 over a die (not shown) and applying heat to heat-set the composite sheet in the box shaped form shown in FIG. 12. The wider fingers 86 and 92 at the four corners of the module are then interlocked and glued together. These wider corner regions of the module provide rigidizing members at the corners of the module and also provide stand-off members to reduce stress on the integrated circuit package during use of the module. In a preferred technique of forming the three dimensionally shaped module, the four rows of fingers are bent at the base with a jig with cam angles that heat-set the fingers at a small angular offset from 90° to the top plane of the module. The fingers 86 and 92 at the four corners of the module are set at preferably a 90° angle relative to the top plane of the module; but the rows of fingers along the sides of the module are angled inwardly slightly so that lower portions of the fingers extend a short distance into the interior region under the module, relative to the tops of the fingers. In this way, when the module is placed over an integrated circuit package, the enclosed area at the bottoms of the fingers is slightly undersized relative to the enclosed area of the exterior leads, so that the bottom portions of the fingers are spread outwardly by the corresponding leads and are held under tension.

FIG. 13 illustrates a cross-sectional view of the completed module. This view shows the top insulating film layer 74 which forms the outer surface of the module housing. The cut-out holes 82 are shown in a central portion of the outer insulating layer 74. The conductive metal layer includes the test pads 94 shown at the base of the cut-out holes 82. The conductive elements 96 are shown extending outwardly from the test pads to the metalized inner faces of the spring-like fingers at the periphery of the module. These metalized portions of the spring-like plastic fingers 84 are preferably of narrower width than their corresponding fingers 84. This is shown in elevation at 98′ in FIG. 13. The insulating sheet 78 is shown as a backing sheet for the metalized conductive circuit pattern, and the outer periphery of this insulating sheet is bent downwardly around the corners of the module as shown at 78′. As a final step in the process, the rigidizing member 80 is bonded to the underside of the module after the module is formed. The rigidizing member provides structural strength for the top surface of the module to resist the downward pressure of the test probes during use for protecting the integrated circuit package tested during use of the module.

FIG. 14 illustrates use of the flex-circuit module 112. This view illustrates a PLCC housing 60 with one of a multiplicity of "J" leads 66 projecting from the exterior of the housing. The translator module is placed over the PLCC device by hand in a spring-like friction fit, so that the spring-like fingers are aligned with the rows of "J" leads along the PLCC device. The translator module is pushed downwardly onto the PLCC device with a downwardly directed force so that each of the leaf spring type fingers on the module is forced downwardly against a corresponding "J" lead so as to flex the fingers outwardly sufficiently to hold them in tension and thereby hold the module on top of the PLCC device. Thus, the inwardly facing metalized portions of the flexible plastic fingers are held in contact with the "J" leads. Since the underside of the module is hollowed out, it accommodates the rectangular configuration of the PLCC housing. The bottom of the module housing can rest against the top surface of the printed circuit board when the module is in place on the circuit package. The spring-like fingers are forced outwardly into the configuration shown in FIG. 14 where the fingers are held under tension in that position because of their normally undersized relationship relative to the projected area around the outer edges of the "J" leads. In a circuit board having a number of these PLCC devices located in various patterns across the surface of the board, these individual translator modules can be rapidly placed on corresponding PLCC devices prior to testing. The array of spring probes 44 in the test unit have spring biased tips 46 which register with corresponding cut-out holes 82 in the top of the module, for contact with the corresponding test pads 94 at the base of the cut-outs. Testing is then carried out by the usual step of drawing the spring probes into pressure contact with the various test points in the circuit under test. In one embodiment, the flexible plastic fingers can be spaced apart on 1,27 mm (50 mil) centers, while this space is translated to the array of test pads at the top on 2,54 mm (100 mil) centers, or more. When the translator module is removed from the PLCC device the plastic metalized fingers spring back inwardly to their normal undersized orientation around the periphery of the module owing to the "memory" of the plastic outer portions 84 of the spring-like fingers. The memory of the spring-like flexible fingers can be provided, in part, by the inherent memory of the thin copper sheet.

FIGS. 15 and 16 show alternative embodiments of the flex-circuit test module. In the embodiment of FIG. 15, the cut-out holes 82 in the top insulating layer 74 of the module can be filled with metal inserts 114. In the embodiment of FIG. 16, the cut-out holes 82 can contain a ring-like metal insert 116 which can enhance electrical contact either with the inside wall of the insert itself or with the test pad 94 at the base of the cut-out 82.

FIGS. 17 through 20 illustrate an alternative embodiment of a translator module made from a composite metalized plastic flex-circuit material. FIG. 17 is a semi-schematic top view of the composite flex-circuit used to form the alternative module. This view illustrates the test pads and metalized spring-like contact fingers schematically, with elements of the combination shown enlarged and out of proportion for simplicity. FIG. 18 is a schematic cross-sectional view taken on a plane through FIG. 17. FIG. 19 illustrates a method for assembling the composite flex-circuit of FIGS. 17 and 18 to form an alternative embodiment of the flex-circuit type translator module. FIG. 20 is a schematic cross-sectional representation, in an enlarged proportion, illustrating the detailed structure of the alternative flex-circuit module.

Referring to FIGS. 17 and 18, the alternative flex-circuit module is made from a composite metalized plastic flex-circuit sheet which includes an outer layer 120 of a flexible self-supporting plastic film; an inner metalized film 122 of electrically conductive metal, such as copper or a beryllium-copper alloy, for example; and a bottom layer 124 of a flexible self-supporting plastic film. The metalized layer 122 which is sandwiched between the outer plastic film 120 and the bottom plastic film 122 is preferably formed into a desired circuit pattern by techniques similar to those described above. In one embodiment, the circuit pattern formed by the conductive metal film can be similar to the circuit pattern 76 illustrated in FIG. 9. Generally, the conductive circuit pattern will be made from a thin, flat continuous sheet of electrically conductive metal approximately 2 to 5 mils thick. At this thickness, the metal layer is in thin self-supporting sheet form. The metal sheet is preferably roll bonded between the outer film 120 and bottom film 124 of the composite flex-circuit. As shown in FIG. 17, the conductive circuit pattern comprises an array of contact points in the form of planar test pads 126 arranged in spaced apart and parallel rows, preferably on a uniform square matrix pattern. The test pads are arranged so they lead to separate elongated thin metal conductor elements 128 which generally fan outwardly from the matrix of text pads to corresponding elongated conductive metal fingers 130 arranged in rows along the four peripheral side portions of the circuit pattern.

In a preferred form of the invention, the plastic film sheets 120 and 124 comprise an approximately 4 mil thick polyamide film such as Du Pont's Kapton. The bottom film 124 is preferably a continuous sheet, in the initial steps of the process; whereas cut-out areas are formed in the outer film sheet 120 in alignment with the test pads 126 and the conductive fingers 130 of the conductive circuit pattern. This arrangement is best illustrated in FIG. 17 which shows an array of cut-out holes 132 extending through the depth of the outer film sheet 120. These cut-out holes are generally rectangular in shape and arranged on a pattern which matches the shape of and is aligned with corresponding test pads 126 of the metalized circuit pattern. Similarly, elongated cut-out holes 134 are formed in the outer film 120 in alignment with the conductive metal fingers 130 of the circuit pattern. The illustration in FIG. 17 shows the cut-out holes 132 and 134 exaggerated in size and out of proportion for clarity.

Once the composite flexible metalized sheet of FIGS. 17 and 18 is formed, the composite sheet is then stamped into a configuration similar to that illustrated in FIG. 11. The multi-layer stamping 136 is illustrated in FIG. 17 as a single layer for simplicity. The cross-sectional view of FIG. 20 illustrates the multi-layer cross-sectional configuration. The resulting stamping 136 has the array of conductive test pads 126 exposed in the central region of the composite stamping through the individual spaced apart cut-out holes 132. The contact fingers 130 of the circuit pattern are formed into individual metalized spring-like contacts 138 in which the conductive fingers 130 are exposed through the cut-outs in the outer layer 120 of the composite sheet. The individual flexible spring-like conductive metal contacts 138 have a metalized outer surface provided by the metalized conductive fingers of the circuit pattern, while the bottom layer 124 of the flex-circuit acts as a backing sheet for the contacts. The composite stamping is next formed into a three-dimensional downwardly opening box-shaped translator module 140. The module is formed by placing the stamping over a folding fixture (not shown) and then folding the ends of the contacts 138 back on themselves, as shown best at the right side of FIG. 19, so as to form individual flexible spring-like conductive fingers of double thickness around the peripheral outer edges of the module. Preferably, the fold-over portions of the fingers are bonded together by a suitable adhesive 142. Once the module is formed with the fold-over flexible fingers, a flat rigidizing member 144 such as a semi-rigid plastic sheet, approximately 0,762 mm (30 mils) thick, of G-10 fiberglass, is bonded to the top inside portion of the module.

FIG. 20 illustrates a cross-sectional view of the completed module 140. This view shows the top insulating film layer 120 which forms the outer surface of the module housing. The cut-out holes 132 are shown for exposing the conductive metal pads 126 at the top of the module. The conductive elements 128 are shown extending from their individual test pads 126, wrapping around the outer ply of the fold-over fingers and leading to the exposed conductive metal faces 130 of the contacts which are exposed to the inside of the module.

In using the flex-circuit module 140, the process is similar to that described for the flex-circuit module 112 above. The translator module is placed over the PLCC device so that the individual spring-like fingers are aligned with the leads along the PLCC device. When the module is pushed downwardly onto the PLCC device, each of the leaf spring-type fingers of the module is forced downwardly against the corresponding leads so as to flex the fingers outwardly sufficiently to hold them in tension and thereby hold the module on top of the PLCC device. Further testing is carried out in a manner described above. The spring-like fingers 138 are held in tension inasmuch as they normally are undersized relative to the projected area around the outer edges of the PLCC leads. The spring-like action of the individual fingers 138 is produced, in part, by the memory of the plastic film 120 and 124 and, in part, by the inherent memory of the metal stamping. As with the other embodiments, the flexible plastic fingers are spaced apart closer than the spacing between the individual test pads at the top of the module. When the module is removed from the PLCC device, the plastic metalized fingers spring back inwardly to their normally undersized orientation around the periphery of the module, owing to the memory of the spring-like fingers.

An advantage of the translator module embodiment of FIGS. 17 through 20 is that the exposed portions of the circuit pattern (the test pads 126 and conductive fingers 130) need only be exposed to one side of the composite flex-circuit material. The resulting composite material is then simply wrapped into the desired configuration to expose these portions of the circuit pattern to the top side and the peripheral inside portions of the resulting module. The result is a reduced manufacturing cost for the flex-circuit module.

Thus, the flex-circuit test module of this invention provides additional space saving advantages. The PLCC'S on the loaded printed circuit board can be mounted closer to one another with the narrowest of board space between them, and yet the test module eliminates any substantial housing thickness of the module around the outside of the PLCC device and thereby occupies little board space during test. In addition, the holes in the top of the module register with corresponding test pads at the base of each hole, and this array of holes provides an additional means for ensuring separate electrical contact between each test probe and a corresponding test pad. Further, the flex-circuit test module provides a substantial cost savings in materials and tooling costs when compared with a molded plastic module, for example. The result of the invention is that printed circuit boards having densely packed PLCC devices with closely spaced leads that are not now possible to be tested can easily be tested with 100% efficiency with the test module of this invention.

## Claims

1. A translator module for use in testing printed circuit boards, the translator module including a rigid housing (16) having top and bottom sides (18,26), the top side of the housing having a fixed upper surface (18) extending across a surface area having a length and a width, and a plurality of electrically conductive test pads (34) on the fixed upper surface of the housing (18), the test pads (34) being disposed thereon in fixed positions with respect to each other in a two-dimensional array in which the test pads (34) are spaced apart across the length and width of the fixed upper surface (18) of the housing (12), said housing having first and second rows of spaced apart spring biased electrical contacts (28,30) affixed to a lower side of the housing, the housing having a fixed recess (27) at the bottom side and being adapted for releasable mounting of the housing in a fixed position over an integrated circuit package (12) mounted among other electrical circuit elements on a loaded printed circuit board (42), the contacts (28,30) comprising individual spring members which are independently compliant and movable relative to the housing (12) for releasable contact under spring tension independently with corresponding leads adjacent the integrated circuit package when the translator module recess (27) is mounted in said fixed position over the integrated circuit package, and means (28a,30a,36) internally electrically connecting the first and second rows of contacts (28,30) to corresponding test pads (34) on the housing.

2. A translator module according to Claim 1, in which the contacts each comprise a leaf spring contact (28) supported at a fixed position on the housing and extending away therefrom to provide spring tension when the contact engages one of the leads adjacent the integrated circuit package.

3. A translator module according to Claim 1 or 2, in which the test pads are each generally planar and have a two-dimensional extent in a common plane defined generally by the fixed upper surface of the housing.

4. A translator module according to any of the Claims 1 to 3, in combination with an electrical test verification unit having an array of spring biased test probes (44), and in which the test pads (34) on the top side of the housing are contacted by spring pressure from the test probes during circuit verification testing.

5. A combination of translator module and an electrical test verification unit according to Claim 4, in which each test pad has a size greater than the size of the test probes (44) adapted to contact the test pads (34).

6. A translator module or combination according to any of the preceding claims, in which each contact has an end extending through the top side of the housing, in which separate electrical conductors (36) at the top side (18) of the housing are electrically connected to the ends of the contacts, the conductors further being electrically connected to corresponding test pads, and in which the top side of the housing comprises a printed wiring board having said electrical conductors (36) and test pads (34).

7. A translator module or combination according to any of the preceding claims, in which the module housing includes downwardly opening and outwardly opening spaced apart slots (32) on opposite sides of the housing, and in which the individual contacts are disposed in the slots for access from below and for being freely moved in response to contact with the leads.

8. A translator module or combination according to any of the preceding claims, in which the in-line spacing between adjacent test pads (34) is greater than the in-line spacing between the electrical contacts in the rows of contacts.

9. A method for testing electrical continuity of circuit elements on a printed circuit board, in which a translator module (10) is used for translating electrical signals between a circuit board under test and an electrical continuity circuit verification test unit, in which the translator module (10) comprises a rigid housing having top and bottom sides, the top side (18) of the housing having a fixed upper surface extending across a surface area having a length and a width, and a plurality of electrically conductive test pads (34) on the fixed upper surface of the housing, the test pads (34) being disposed thereon in fixed positions with respect to each other in a two-dimensional array in which the test pads are spaced apart across the length and width of the fixed upper surface of the housing, the method comprising:
providing first and second rows of spaced apart spring-biased electrical contacts (28) affixed to a lower side of the housing, the contacts comprising individual spring members (28) which are independently compliant and movable relative to the housing, the first and second rows of contacts being internally electrically connected to corresponding test pads;
placing the translator module (10) over an integrated circuit package on the circuit board under test, so that the electrical contacts are releasably engaged with respective electrical leads adjacent the integrated circuit package and the contacts are held under spring tension independently with the corresponding leads while the module is mounted to the integrated circuit package;
providing an array of test probes (44) in the electrical continuity circuit verification test unit wherein the test probes are arranged for contact with individual test pads (34) on the upper surface of the housing; and
drawing the array of test probes (44) and the test pads (34) on the module into pressure contact to establish electrical continuity from the leads on the integrated circuit package to corresponding test probes, via the contacts on the module housing and their corresponding electrical connections to the test pads on the housing, for conducting electrical circuit continuity test verification signals from circuitry on the printed circuit board to the integrated circuit leads.

10. The method according to claim 9, wherein the contacts each comprise a separate leaf spring contact (28) supported at a fixed position on the housing and extending away therefrom, thereby providing spring tension which is retained by the leaf spring when the contact engages one of the leads adjacent the integrated circuit package.

11. The method according to claim 9 or 10, wherein the test pads (34) are each generally planar and have a two-dimensional extent with a flat surface in a common plane defined by a fixed upper surface of the housing, so that the test probes in the test unit apply spring pressure to the flat surfaces of the test pads during testing.

12. The method according to claims 9 to 11, wherein a plurality of said translator modules (10) are placed over a corresponding plurality of integrated circuit packages on the circuit board, and the test probes (44) are drawn into contact with the translator modules (10) to simultaneously test a plurality of said integrated circuit packages.

13. The method according to claims 9 to 12, wherein the in-line spacing between the test pads (34) is greater than the in-line spacing between leads adjacent the integrated circuit package.

14. A translator module according to any of Claims 1 to 8 in which the leads adjacent the IC package are terminals on the package.

15. A translator module according to any of Claims 1 to 8 in which the leads adjacent the IC package are leads on the board in contact with terminals on the IC package.

## Patentansprüche

1. Übersetzermodul zur Verwendung beim Testen gedruckter Schaltungskarten, enthaltend ein starres Gehäuse (16) mit Ober- und Unterseiten (18, 26), wobei die Oberseite des Gehäuses eine feste Oberfläche (18) aufweist, die sich über einen Oberflächenbereich erstreckt, der eine Länge und eine Breite hat, mit mehreren elektrisch leitfähigen Prüfflecken (34) auf der festen Oberfläche des Gehäuses (18), die darauf an festen gegenseitigen Positionen in einer zweidimensionalen Gruppe angeordnet sind, in der die Prüfflecken über die Länge und die Breite der festen Oberfläche (18) des Gehäuses (12) voneinander beabstandet sind, wobei das Gehäuse erste und zweite Reihen in gegenseitigem Abstand angeordneter, federbeaufschlagter elektrischer Kontakte (28, 30) aufweist, die an einer Unterseite des Gehäuses befestigt sind, und das Gehäuse eine feste Ausnehmung (27) an der Unterseite aufweist und dazu eingerichtet ist, das Gehäuse an einer festen Position über einer integrierten Schaltungspackung (12) lösbar zu montieren, die neben anderen elektrischen Schaltkreiselementen auf einer bestückten Druckschaltkarte (42) angebracht ist, wobei die Kontakte (28, 30) einzelne Federelemente aufweisen, die unabhängig nachgiebig und relativ zum Gehäuse (12) beweglich sind, um unter Federspannung unabhängig mit entsprechenden Leitern benachbart der integrierten Schaltungspackung lösbar in Kontakt zu gelangen, wenn die Ausnehmung (27) des Übersetzermoduls an der genannten festen Position über der integrierten Schaltungspackung angebracht wird, und mit Einrichtungen (28a, 30a, 36), die intern die ersten und zweiten Kontaktreihen (28, 30) mit entsprechenden Prüfflecken (34) am Gehäuse elektrisch verbinden.

2. Übersetzermodul nach Anspruch 1, bei dem die Kontakte jeweils einen Blattfederkontakt (28) aufweisen, der an einer festen Position am Gehäuse angebracht ist und sich davon weg erstreckt, um Federspannung zu erzeugen, wenn der Kontakt einen der Leiter benachbart der integrierten Schaltungspackung berührt.

3. Übersetzermodul nach Anspuch 1 oder 2, bei dem die Prüfflecken jeweils im wesentlichen planar sind und eine zweidimensionale Ausdehung in einer gemeinsamen Ebene aufweisen, die im wesentlichen durch die feste Oberfläche des Gehäuses definiert ist.

4. Übersetzermodul nach einem der Ansprüche 1 bis 3 in Kombination mit einer elektrischen Nachprüfeinheit, die eine Gruppe federberbeaufschlagter Prüfsonden (44) enthält, und in dem die Prüfflecken (34) auf der Obereite des Gehäuses unter Federdruck von den Prüfsonden während des Schaltungsnachprüftests kontaktiert werden.

5. Kombination aus einem Übersetzermodul und einer elektrischen Nachprüfeinheit nach Anspruch 4, bei der jeder Testfleck eine Größe aufweist, die größer als die Größe der Testsonden (44) ist, die zur Berührung der Testflecken (34) eingerichtet sind.

6. Übersetzermodul oder Kombination nach einem der vorhergehenden Ansprüche, bei dem bzw. der jeder Kontakt ein Ende aufweist, das sich durch die Oberseite des Gehäuses erstreckt, wobei getrennte elektrische Leiter (36) an der Oberseite (18) des Gehäuses elektrisch mit den Enden der Kontakte verbunden sind und die Leiter weiterhin elektrisch mit entsprechenden Prüfflecken verbunden sind und wobei die Oberseite des Gehäuses eine gedruckte Verdrahtungskarte aufweist, die die genannten elektrischen Leiter (36) und die Prüfflecken (34) enthält.

7. Übersetzermodul oder Kombination nach einem der vorhergehenden Ansprüche, bei dem bzw. der das Modulgehäuse sich nach unten öffnende und nach außen öffnende, im Abstand angeordnete Schlitze (32) an gegenüberliegenden Seiten des Gehäuses aufweist und bei dem bzw. der die einzelnen Kontakte in den Schlitzen zum Zugang von unten zur freien Beweglichkeit in Abhängigkeit vom Kontakt mit den Leitern angeordnet sind.

8. Übersetzermodul oder Kombination nach einem der vorhergehenden Ansprüche, bei dem bzw. der der gegenseitige Abstand benachbarter Reihen von Prüfflecken (34) größer als der Reihenabstand zwischen den elektrischen Kontakten in den Kontaktreihen ist.

9. Verfahren zum Prüfen der elektrischen Durchgängigkeit von Schaltungslementen auf einer Druckschaltkarte, bei dem ein Übersetzermodul (10) zum Übersetzen elektrischer Signale zwischen einer in Prüfung befindlichen Schaltungskarte und einer elektrischen Schaltungsdurchgängigkeits-Nachprüfeinheit verwendet wird, wobei das Übersetzermodul (10) ein starres Gehäuse aufweist, das Ober- und Unterseiten hat, wobei die Oberseite (18) des Gehäuses eine feste Oberfläche aufweist, die sich über einen Oberflächenbereich erstreckt, der eine Länge und eine Breite hat und mit mehreren elektrisch leitfähigen Prüfflecken (34) auf der festen Oberfläche des Gehäuses, die darauf in festen gegenseitigen Positionen in einer zweidimensionalen Gruppe angeordnet sind, in der die Prüfflecken über die Länge und die Breite der festen Oberfläche des Gehäuses gegenseitigen Abstand haben, enthaltend die folgenden Schritte:
Anordnen von ersten und zweiten Reihen gegenseitig beabstandeter, federbeaufschlagter elektrischer Kontakte (28), die an einer Unterseite des Gehäuses befestigt sind und einzelne Federelemente (28) aufweisen, die unabhängig nachgiebig und relativ zum Gehäuse beweglich sind, wobei die ersten und zweiten Kontaktreihen intern elektrisch mit entsprechenden Prüfflecken verbunden sind;
Anordnen des Übersetzermoduls (10) über einer integrierten Schaltungspackung auf der in Prüfung befindlichen Schaltungskarte derart, daß die elektrischen Kontakte lösbar mit den entsprechenden elektrischen Leitern benachbart der integrierten Schaltungspackung in Eingriff gelangen und die Kontakte unter Federspannung unabhängig mit den entsprechenden Leitern in Berührung gehalten werden, während das Modul an der integrierten Schaltungspackung angebraht wird;
Vorsehen einer Gruppe von Prüfsonden (44) in der elektrischen Durchgängigkeits-Schaltungsnachprüfeinheit, wobei die Prüfsonden zur Berührung mit einzelnen Prüfflecken (34) an der Oberfläche des Gehäuses angeordnet werden; und
Ziehen der Gruppe der Prüfsonden (44) und der Prüfflecken (34) am Modul in Druckkontakt zur Einrichtung elektrischer Durchgängigkeit von den Leitern auf der integrierten Schaltungspackung zu entsprechenden Prüfsonden über die Kontakte auf dem Modulgehäuse und ihren entsprechenden elektrischen Verbindungen zu den Prüfflecken am Gehäuse zum Leiten elektrischer Schaltungsdurchgängigkeitsnachprüfsignalen von der Schaltung auf der Druckschaltkarte zu den Leitern der integrierten Schaltung.

10. Verfahren nach Anspruch 9, bei dem die Kontakte jeweils einen getrennten Blattfederkontakt (28) aufweisen, der an einer festen Position an dem Gehäuse befestigt ist und sich davon weg erstreckt, um dadurch eine Federspannung zu erzeugen, die von der Blattfeder aufrechterhalten wird, wenn der Kontakt einen der Leiter benachbart der integrierten Schaltungspackung berührt.

11. Verfahren nach Anspuch 9 oder 10, bei dem die Prüfflecken (34) jeweils im wesentlichen planar sind und eine zweidimensionale Ausdehung mit einer flachen Oberfläche in einer gemeinsamen Ebene aufweisen, die von einer festen Oberfläche des Gehäuses definiert wird, so daß die Prüfsonden in der Prüfeinheit Federdruck auf die flachen Oberflächen der Prüfflecken während der Untersuchung aufbringen.

12. Verfahren nach den Ansprüchen 9 bis 11, bei dem mehrere solcher Übersetzermodule (10) über einer entsprechenden Vielzahl integrierter Schaltungspackungen auf der Schaltungskarte angeordnet werden und die Prüfsonden (44) mit den Übersetzermodulen (10) in Kontakt gebracht werden, um gleichzeitig mehrere solcher integrierter Schaltungspackungen zu prüfen.

13. Verfahren nach den Ansprüchen 9 bis 12, bei dem der Reihenabstand zwischen den Prüfflecken (34) größer als der Reihenabstand zwischen Leitern benachbart der integrierten Schaltungspackung ist.

14. Übersetzermodul nach einem der Ansprüche 1 bis 8, bei dem die Leiter benachbart der integrierten Schaltungspackung Anschlüsse an der Packung sind.

15. Übersetzermodul nach einem der Ansprüche 1 bis 8, bei dem die Leiter benachbart der integrierten Schaltungspackung Leiter auf der Schaltkarte sind, die mit Anschlüssen an der integrierten Schaltungspackung in Berührung sind.

## Revendications

1. Module de translation à utiliser dans le contrôle de plaquettes de circuits imprimés, le module de translation incluant une capsule rigide (16) ayant des côtés supérieur et inférieur (18,26), le côté supérieur de la capsule ayant une face supérieure fixe (18) s'étendant d'un côté à l'autre d'une aire de surface ayant une longueur et une largeur, et une pluralité de pastilles de contrôle conductrices électriquement (34) sur la face supérieure fixe (18) de la capsule, les pastilles de contrôle (34) étant disposées dessus dans des positions fixes les unes par rapport aux autres dans un réseau bidimensionnel dans lequel les pastilles de contrôle (34) sont espacées les unes des autres sur la longueur et la largeur de la face supérieure fixe (18) de la capsule (12), ladite capsule ayant des premières et deuxièmes rangées de contacts électriques à ressorts (28,30) espacés les uns des autres et attachés au-dessous de la capsule, la capsule ayant un creux fixe (27) du côté inférieur et étant adaptée à un montage de la capsule de façon détachable : dans une position fixe par-dessus un boîtier de circuit intégré (12) monté parmi d'autres éléments de circuits électriques sur une plaquette de circuits imprimés pourvue de composants (42), les contacts (28,30) comprenant des organes à ressort individuels qui sont indépendamment élastiques et mobiles relativement à la capsule (12) pour un contact sous la tension d'un ressort de façon détachable et indépendante avec des sorties correspondantes adjacentes au boîtier de circuit intégré lorsque le creux (27) du module de translation est monté dans ladite position fixe par-dessus le boîtier de circuit intégré, et des moyens (28a,30a,36) connectant électriquement à l'intérieur les premières et deuxièmes rangées de contacts (28,30) à des pastilles de contrôle (34) correspondantes sur la capsule.

2. Module de translation selon la revendication 1, dans lequel chaque contact comprend un contact à ressort à lame (28) supporté à une position fixe sur la capsule et se prolongeant à partir de là pour fournir une tension de ressort lorsque le contact est engagé sur une des sorties adjacentes au boîtier de circuit intégré.

3. Module de translation selon la revendication 1 ou 2, dans lequel les pastilles de contrôle sont toutes planes d'une manière générale et s'étendent de façon bidimensionnelle dans un plan commun défini d'une manière générale par la face supérieure fixe de la capsule.

4. Module de translation selon l'une quelconque des revendications 1 à 3, en combinaison avec une unité de contrôle de vérification électrique ayant un réseau de sondes de contrôle à ressorts (44), et dans lequel les sondes de contrôle viennent en contact avec les pastilles de contrôle (34) sur le côté supérieur de la capsule par pression des ressorts des sondes de contrôle durant le contrôle de vérification de circuits.

5. Combinaison d'un module de translation et d'une unité de contrôle de vérification électrique selon la revendication 4, dans laquelle chaque pastille de contrôle a une taille supérieure à la taille des sondes de contrôle (44) adaptées à venir en contact avec les pastilles de contrôle (34).

6. Module de translation ou combinaison selon l'une quelconque des revendications précédentes, dans lequel chaque contact a une extrémité s'étendant à travers le côté supérieur de la capsule, dans lequel des conducteurs électriques séparés (36) du côté supérieur (18) de la capsule sont connectés électriquement aux extrémités des contacts, les conducteurs étant en outre connectés électriquement à des pastilles de contrôle correspondantes, et dans lequel le côté supérieur de la capsule comprend un tableau de connexions imprimé ayant lesdits conducteurs électriques (36) et lesdites pastilles de contrôle (34).

7. Module de translation ou combinaison selon l'une quelconque des revendications précédentes, dans lequel la capsule du module inclut des fentes (32) s'ouvrant vers le bas et s'ouvrant en dehors, espacées les unes des autres, sur des côtés opposés de la capsule, et dans lequel les contacts individuels sont disposés dans les fentes pour être accédés par-dessous et pour se déplacer librement en réponse au contact avec les sorties.

8. Module de translation ou combinaison selon l'une quelconque des revendications précédentes, dans lequel l'espacement linéaire entre des pastilles de contrôle (34) adjacentes est supérieur à l'espacement linéaire entre les contacts électriques dans les rangées de contacts.

9. Procédé de contrôle de la continuité électrique d'éléments de circuits sur une plaquette de circuits imprimés, dans lequel un module de translation (10) est utilisé pour translater des signaux électriques entre une plaquette de circuits imprimés qui est contrôlée et une unité de contrôle de vérification de la continuité électrique de circuits, dans lequel le module de translation (10) comprend une capsule rigide ayant des côtés supérieur et inférieur, le côté supérieur (18) de la capsule ayant une face supérieure fixe s'étendant d'un côté à l'autre d'une aire de surface ayant une longueur et une largeur, et une pluralité de pastilles de contrôle conductrices électriquement (34) sur la face supérieure fixe de la capsule, les pastilles de contrôle (34) étant disposées dessus dans des positions fixes les unes par rapport aux autres dans un réseau bidimensionnel dans lequel les pastilles de contrôle sont espacées les unes des autres sur la longueur et la largeur de la face supérieure fixe de la capsule, le procédé consistant à :
- fournir des premières et deuxièmes rangées de contacts électriques à ressorts (28) espacés les uns des autres et attachés au-dessous de la capsule, les contacts comprenant des organes à ressort individuels (28) qui sont indépendamment élastiques et mobiles relativement à la capsule, les premières et deuxièmes rangées de contacts étant connectées électriquement à l'intérieur à des pastilles de contrôle correspondantes;
- placer le module de translation (10) par-dessus un boîtier de circuit intégré sur la plaquette de circuits imprimés qui est contrôlée, de telle sorte que les contacts électriques s'engagent de façon détachable sur des sorties électriques respectives adjacentes au boîtier de circuit intégré et que les contacts sont retenus sous une tension de ressort de façon indépendante avec les sorties correspondantes pendant que le module est monté sur le boîtier de circuit intégré;
- fournir un réseau de sondes de contrôle (44) dans l'unité de contrôle de vérification de la continuité électrique de circuits dans laquelle les sondes de contrôle sont arrangées pour venir en contact avec des pastilles de contrôle individuelles (34) sur la face supérieure de la capsule; et
- amener le réseau de sondes de contrôle (44) et les pastilles de contrôle (34) sur le module en contact par pression pour établir une continuité électrique depuis les sorties sur le boîtier de circuit intégré jusqu'aux sondes de contrôle correspondantes, via les contacts sur la capsule du module et leurs connexions électriques correspondantes avec les pastilles de contrôle sur la capsule, pour transmettre des signaux de contrôle de vérification de la continuité électrique de circuits depuis les éléments de circuits sur la plaquette de circuits imprimés jusqu'aux sorties de circuit intégré.

10. Procédé selon la revendication 9, dans lequel chaque contact comprend un contact à ressort à lame séparé (28) supporté à une position fixe sur la capsule et se prolongeant à partir de là, fournissant par ce moyen une tension de ressort qui est retenue par le ressort à lame lorsque le contact est engagé sur une des sorties adjacentes du boîtier de circuit intégré.

11. Procédé selon la revendication 9 ou 10, dans lequel les pastilles de contrôle (34) sont toutes planes d'une manière générale et s'étendent de façon bidimensionnelle avec une surface plane dans un plan commun défini par une face supérieure fixe de la capsule, de telle sorte que les sondes de contrôle dans l'unité de contrôle appliquent une pression de ressort aux surfaces planes des pastilles de contrôle durant le contrôle.

12. Procédé selon les revendications 9 à 11, dans lequel une pluralité desdits modules de translation (10) est placée au-dessus d'une pluralité correspondante de boîtiers de circuits intégrés sur la plaquette de circuits imprimés, et dans lequel les sondes de contrôle (44) sont amenées en contact avec les modules de translation (10) pour contrôler simultanément une pluralité desdits boîtiers de circuits intégrés.

13. Procédé selon les revendications 9 à 12, dans lequel l'espacement linéaire entre les pastilles de contrôle (34) est supérieur à l'espacement linéaire entre les sorties adjacentes au boîtier de circuit intégré.

14. Module de translation selon l'une quelconque des revendications 1 à 8, dans lequel les sorties adjacentes au boîtier à circuit intégré sont des bornes sur le boîtier.

15. Module de translation selon l'une quelconque des revendications 1 à 8, dans lequel les sorties adjacentes au boîtier à circuit intégré sont des sorties sur la plaquette en contact avec des bornes sur le boîtier à circuit intégré.
